# FASCICULE DE BREVET EUROPEEN

(11) **EP 2 564 226 B1**
(45) Date de publication et mention de la délivrance du brevet: **22.01.2014**
(21) Numéro de dépôt: 11715565.5
(22) Date de dépôt: 21.04.2011
(51) Int. Cl.: G01R 33/02, G01R 33/04, G01R 33/05

(54) **MAGNETOMETRE A PORTE DE FLUX ET PROCEDE DE FABRICATION DE CE MAGNETOMETRE**
FLUXGATE-MAGNETOMETER UND VERFAHREN ZUR HERSTELLUNG DES MAGNETOMETERS
FLUXGATE-MAGNETOMETER AND METHOD OF MANUFACTURING THIS MAGNETOMETER

(30) Priorité: 29.04.2010 FR 1053295
(43) Date de publication de la demande: 06.03.2013
(73) Titulaire: Commissariat à l'Énergie Atomique et aux Énergies Alternatives, 75015 Paris (FR)
(72) Inventeur: VUILLERMET, Yannick, F-73000 Chambery (FR)
(74) Mandataire: Colombo, Michel
(86) Numéro de dépôt international: PCT/EP2011/056477
(87) Numéro de publication internationale: WO 2011/134904

(56) Documents cités:
- JP-A- 2006 214 776
- US-A- 5 014 006
- US-A1- 2007 222 441

## Description

L'invention concerne un magnétomètre à porte de flux pour mesurer une composante B_{tz} d'un champ magnétique le long d'une direction Z. L'invention concerne également un procédé de fabrication de ce magnétomètre.

Les magnétomètres à porte de flux ou à vanne de flux sont également connus sous le terme anglais de « fluxgate ». Les principes de fonctionnement d'un tel magnétomètre sont bien connus et ne sont pas décrits ici plus en détail. Pour un rappel de ces principes de fonctionnement, il est possible de se référer aux documents suivants :
P. Ripka, « Advances in fluxgate sensors », Sensor and Actuators A : Physical 106 (2003)
L. Chiesi, « Planar 2D fluxgate magnetometer for CMOS electronic compass », Thèse de doctorat EPFL, Hartung - Gorre (1999)

De l'état de l'art est également divulgué dans les demandes de brevet US5014006, US2007222441, et JP2006214776.

Aujourd'hui, il existe un grand nombre d'applications pour des magnétomètres triaxes, c'est-à-dire capables de mesurer la projection du champ magnétique sur trois axes de mesure non colinéaires répartis dans des plans orthogonaux. Généralement, les axes de mesures sont orthogonaux entre eux. Ces magnétomètres triaxes permettent de mesurer trois composantes du champ magnétique le long de chacun des axes de mesure. Ces magnétomètres triaxes permettent donc de mesurer la direction du champ magnétique. Ils peuvent alors être utilisés comme boussole, centrale d'altitude ou autres.

Pour réduire l'encombrement et le coût des magnétomètres et faciliter leur intégration dans des dispositifs électroniques plus complexes, il est souhaitable de les fabriquer à l'aide de procédés collectifs de fabrication microélectronique. Ces procédés sont les mêmes que ceux utilisés pour fabriquer, par exemple, des puces électroniques. Lorsqu'ils sont fabriqués par ces procédés de fabrication microélectronique, les magnétomètres sont réalisés en déposant sur un substrat (connus sous le terme de galette ou « wafer » en anglais) une succession de couches qui sont gravées les unes après les autres pour donner sa forme finale au magnétomètre. Un grand nombre de magnétomètres sont fabriqués simultanément sur le même substrat. Ensuite, le substrat est découpé pour séparer mécaniquement les uns des autres les différents magnétomètres fabriqués sur ce même substrat.

Dans le cas des magnétomètres triaxes, le procédé de fabrication microélectronique présente en plus l'avantage de pouvoir disposer très précisément les différents axes de mesures les uns par rapport aux autres.

Le déposant connaît donc des magnétomètres à porte de flux pour mesurer une composante B_{tz} d'un champ magnétique le long d'une direction Z, ce magnétomètre comportant :
- un substrat s'étendant essentiellement parallèlement à un plan XY parallèle à des directions X et Y horizontales et perpendiculaire à la direction Z,
- un premier noyau magnétique, fabriqué sur le substrat, présentant un segment horizontal s'étendant parallèlement à la direction Y pour canaliser une composante B_{ty} du champ magnétique,
- une première bobine d'excitation et une première bobine de mesure enroulées autour du segment horizontal pour mesurer l'intensité du champ magnétique dans ce segment horizontal.

Dans la suite de cette description, la direction « verticale » est celle qui est perpendiculaire au plan XY. Une direction horizontale est une direction parallèle au plan XY.

Par exemple, un tel magnétomètre est divulgué dans la demande de brevet W0 2008 0161 198.

Il a également été proposé, dans le but d'améliorer la précision du positionnement de l'axe vertical de mesure de réaliser un noyau magnétique vertical sur le même substrat que celui incorporant les autres axes de mesure par des procédés de fabrication microélectronique. Ceci est par exemple divulgué dans la demande de brevet WO 0 144 826. Des bobines d'excitation et de mesure sont alors enroulées autour du noyau vertical pour mesurer la composante B_{tz} du champ magnétique.

Toutefois, la réalisation d'un tel noyau vertical pose des difficultés. En effet, il existe une contradiction entre les deux exigences suivantes :
1) le noyau vertical doit être long pour permettre l'enroulement d'un grand nombre de spires des bobines d'excitation et de mesure afin d'accroître la sensibilité de la mesure de la composante B_{tz}, et
2) le noyau vertical doit être aussi court que possible pour diminuer la hauteur du magnétomètre et réduire son encombrement.

Le noyau vertical doit également être suffisamment court pour permettre sa réalisation par des moyens de microélectronique.

Dans la suite de cette description, par sensibilité, on fait par exemple référence à la sensibilité de l'amplitude de l'harmonique d'ordre deux à une variation de l'amplitude de la composante mesurée du champ magnétique. L'harmonique d'ordre deux est l'harmonique ayant pour fréquence 2*f₀, où f₀ est la fréquence du courant d'excitation circulant dans les bobines d'excitation. En variante, il pourrait s'agir d'une autre grandeur représentative de la sensibilité du magnétomètre telle que, par exemple, la sensibilité de la détection synchrone.

Par « hauteur » du magnétomètre on désigne son épaisseur maximale dans la direction verticale.

Ainsi, toute réduction de la hauteur du magnétomètre se traduit par une diminution de la sensibilité de la mesure de la composante B_{tz}.

L'invention vise à remédier à cet inconvénient. Elle a donc pour objet un magnétomètre dans lequel le premier noyau présente également au moins un premier segment incliné s'étendant dans une direction en dehors du plan XY et apte à diriger au moins une partie du flux magnétique de la composante B_{tz} vers le segment horizontal.

Par « segment incliné », on désigne ici un segment dont la longueur ou la largeur s'étend dans une direction dont la projection sur un axe vertical est non nulle.

Dans le magnétomètre ci-dessus, le segment incliné permet de diriger vers le segment horizontal une partie du flux magnétique de la composante B_{tz} perpendiculaire au plan de ce substrat. Grâce à cela, pour mesurer avec une bonne sensibilité la composante B_{tz} du champ magnétique, il n'est plus nécessaire d'enrouler un grand nombre de spires le long du segment incliné du noyau. Ici, ces spires sont enroulées autour du segment horizontal du noyau ce qui n'augmente pas la hauteur du magnétomètre. Il est donc à la fois possible de réduire la hauteur du magnétomètre sans pour autant diminuer la sensibilité de la mesure de la composante B_{tz}.

Les modes de réalisation de ce magnétomètre peuvent comporter une ou plusieurs des caractéristiques suivantes :
■ le magnétomètre comprend des moyens de réjection de la composante B_{ty} de la mesure réalisée par la première bobine de mesure;
■ les moyens de réjection comprennent :
   - au moins un deuxième noyau magnétique apte à canaliser lui aussi la composante B_{ty}, et
   - des deuxièmes bobines d'excitation et de mesure enroulées autour du deuxième noyau pour mesurer la composante B_{ty} à rejeter de la mesure réalisée avec la première bobine de mesure;
■ le deuxième noyau présente également au moins un premier segment incliné s'étendant dans une direction en dehors du plan XY;
■ ledit au moins un premier segment incliné du deuxième noyau est apte à diriger le flux de la composante B_{tz} vers le segment horizontal de ce deuxième noyau dans une direction opposée à la direction du flux de la composante B_{tz} dans le segment horizontal du premier noyau;
■ les moyens de réjection comprennent une unité électronique de traitement apte :
   - à additionner et, en alternance, à soustraire électroniquement l'une à l'autre les mesures des première et deuxième bobines de mesure de manière à rejeter, en alternance, la composante B_{ty} et la composante B_{tz} pour mesurer, à partir des mêmes noyaux et à l'aide des mêmes bobines, soit la composante B_{tz} soit la composante B_{ty}, et
   - à commander une source de courant alimentant la première ou la deuxième bobines d'excitation de manière à inverser la direction du champ magnétique d'excitation dans un seul des segments horizontaux des premier et deuxième noyaux magnétiques pour rejeter également le champ magnétique d'excitation aussi bien lorsque les mesures des première et deuxième bobines sont additionnées que soustraites;
■ le magnétomètre comporte :
   - une troisième bobine de mesure enroulée en sens inverse de la première bobine de mesure autour du segment horizontal du premier noyau,
   - une troisième bobine d'excitation enroulée en sens inverse de la deuxième bobine d'excitation du segment horizontal du deuxième noyau, et
   - une unité électronique de traitement apte :
      à additionner, en alternance, les mesures des première et deuxième bobines de mesure et les mesures des première et troisième bobines de mesure de manière à rejeter, en alternance, la composante B_{ty} et la composante B_{tz} pour mesurer, à partir des mêmes noyaux, soit la composante B_{tz} soit la composante B_{ty}, et
      à commander l'alimentation, en alternance, des première et deuxième bobines d'excitation et des première et troisième bobines d'excitation de manière à inverser la direction du champ magnétique d'excitation dans un seul des segments horizontaux pour rejeter également le champ magnétique d'excitation aussi bien lorsque les mesures des première et deuxième bobines de mesure et les mesures des première et troisième bobines de mesure sont additionnées;
■ les première et deuxième bobines de mesure sont raccordées électriquement en série de manière à soustraire l'une à l'autre les composantes B_{ty} canalisées, respectivement, par les premier et deuxième noyaux;
■ chaque noyau comprend au moins un deuxième segment incliné dirigé dans une direction opposée à celle du premier segment incliné, tous les segments inclinés dirigés dans une même direction étant regroupés d'un même côté du segment horizontal et tous les segments inclinés dirigés dans la direction opposée étant regroupés d'un autre côté du segment horizontal;
■ chaque noyau comprend plus de dix segments inclinés;
■ le magnétomètre comprend :
   - au moins un noyau magnétique supplémentaire présentant un segment horizontal s'étendant parallèlement au plan XY dans une direction sécante avec la direction Y pour canaliser également une composante Bₜₓ du champ magnétique mesuré le long de la direction X, et
   - des bobines d'excitation et de mesure enroulées autour de ce segment horizontal supplémentaire pour mesurer la composante B_{tz}.

Ces modes de réalisation du magnétomètre présentent en outre les avantages suivants :
- l'utilisation d'un moyen de réjection de la composante B_{ty} permet de mesurer la composante B_{tz} indépendamment de la composante B_{ty};
- utiliser un deuxième noyau magnétique présentant un segment horizontal capable de canaliser la composante B_{ty} permet de rejeter simplement la composante B_{ty} de la mesure de la composante B_{tz};
- utiliser un deuxième noyau présentant également un segment incliné accroît la sensibilité de la mesure de la composante B_{tz};
- utiliser un segment incliné sur le deuxième noyau qui permet de diriger le flux de la composante B_{tz} dans un sens opposé à celui du flux de cette même composante dans le premier noyau facilite la réjection de la composante B_{ty} sans avoir recours à un traitement électronique;
- utiliser une unité de traitement apte à mesurer, en alternance, les composantes B_{ty} et B_{tz} à l'aide des mêmes noyaux magnétiques et des mêmes bobines de mesure simplifie la réalisation du magnétomètre;
- utiliser une troisième bobine de mesure et une troisième bobine d'excitation permet de simplifier l'unité électronique de traitement utilisée pour mesurer, en alternance, les composantes B_{ty} et B_{tz} en utilisant les mêmes noyaux magnétiques;
- raccorder en série les première et deuxième bobines de mesure permet de rejeter la composante B_{ty} des mesures de la composante B_{tz} sans avoir recours à un traitement électronique;
- utiliser un noyau équipé de segments inclinés dans des directions opposées et réparti chacun d'un côté du segment horizontal permet d'accroître la sensibilité du magnétomètre;
- utiliser un noyau équipé de plus de dix segments inclinés accroît la sensibilité du magnétomètre;
- la présence d'un noyau magnétique s'étendant dans le plan XY dans une direction sécante avec la direction Y permet d'obtenir un magnétomètre triaxe.

L'invention a également pour objet un procédé de fabrication d'un magnétomètre à porte de flux pour mesurer une composante B_{tz} d'un champ magnétique le long d'une direction Z, ce procédé comportant :
- la fourniture d'un substrat s'étendant parallèlement à un plan XY parallèle à des directions X et Y horizontales et perpendiculaire à la direction Z,
- le dépôt et/ou la gravure d'un segment horizontal d'un noyau magnétique, ce segment horizontal s'étendant parallèlement à la direction Y pour canaliser une composante B_{ty} du champ magnétique,
- le dépôt et/ou la gravure d'une bobine d'excitation et d'une bobine de mesure enroulées autour du segment horizontal pour mesurer l'intensité du champ magnétique dans ce segment horizontal,
- le dépôt et/ou la gravure d'un segment incliné du noyau, ce segment incliné s'étendant dans une direction en dehors du plan XY et étant apte à diriger au moins une partie du flux magnétique de la composante B_{tz} vers le segment horizontal.

L'invention sera mieux comprise à la lecture de la description qui va suivre, donnée uniquement à titre d'exemple non limitatif et faite en se référant aux dessins sur lesquels :
- la figure 1 est une illustration schématique et en perspective d'un magnétomètre triaxe,
- la figure 2 est une illustration schématique et en coupe verticale d'un noyau magnétique du magnétomètre de la figure 1 ;
- la figure 3 est une illustration schématique et en perspective du noyau magnétique de la figure 2 ;
- la figure 4 est une illustration simplifiée et en perspective du sens d'enroulement de bobines autour du noyau magnétique des figures 2 et 3 ;
- la figure 5 est une illustration schématique et en coupe partielle d'une portion du noyau magnétique des figures 2 et 3 ;
- la figure 6 est un organigramme d'un procédé de fabrication du magnétomètre de la figure 1 ;
- les figures 7 à 21 sont des illustrations schématiques en coupe verticale de différentes étapes du procédé de la figure 6;
- la figure 22 est une illustration schématique et en vue de dessus d'un deuxième mode de réalisation du magnétomètre de la figure 1;
- la figure 23 est une illustration schématique et simplifiée des bobines du magnétomètre de la figure 22;
- la figure 24 est une illustration schématique et en vue de dessus d'un troisième mode de réalisation du magnétomètre de la figure 1 ;
- les figures 25 à 30 sont des illustrations schématiques et en coupe verticale de différents modes de réalisation d'un noyau magnétique susceptible d'être mis en oeuvre dans le magnétomètre de la figure 1; et
- la figure 31 est une illustration schématique et en perspective d'un mode de réalisation supplémentaire d'un noyau magnétique susceptible d'être mis en oeuvre dans le magnétomètre de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

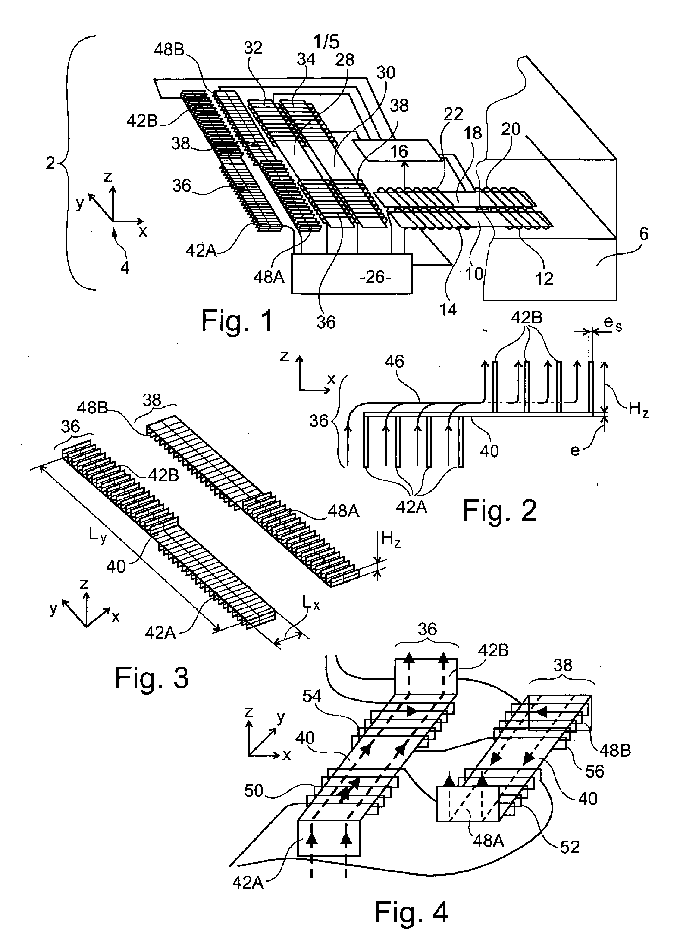

La figure 1 représente un magnétomètre 2 triaxe adapté pour mesurer un champ magnétique de faible intensité, c'est-à-dire un champ magnétique inférieur à 50 à 100 µT. Par exemple, le magnétomètre 2 est destiné à mesurer le champ magnétique terrestre.

Ce magnétomètre 2 comporte trois axes de mesure respectivement parallèles aux directions X, Y et Z d'un référentiel 4. Ici, les directions X, Y et Z sont orthogonales entre elles. Les composantes du champ magnétique mesurées selon les directions X, Y et Z sont notées, respectivement, Bₜₓ, B_{ty} et B_{tz} dans la suite de cette description.

Le magnétomètre 2 est fabriqué à partir d'un procédé de fabrication microélectronique. Ainsi, il est réalisé par empilement et gravure de couches successives sur un substrat 6 partiellement représenté sur la figure 1. Le substrat 6 s'étend essentiellement parallèlement à un plan horizontal XY parallèle aux directions X et Y.

Le magnétomètre 2 comprend trois paires de noyaux magnétiques solidaires du substrat 6. Chaque paire de noyaux magnétiques est utilisée pour mesurer spécifiquement l'une des composantes Bₜₓ, B_{ty} et B_{tz} du champ magnétique.

La première paire de noyaux magnétiques comprend un noyau magnétique 10 destiné à canaliser et à concentrer le flux magnétique de la composante Bₜₓ. A cet effet, ce noyau 10 s'étend uniquement parallèlement à la direction X.

Le noyau 10 est réalisé dans un matériau magnétique présentant une perméabilité relative maximale supérieure à 100 et, de préférence, supérieure à 1000. Typiquement, le matériau magnétique est un matériau ferromagnétique. Par exemple, il s'agit d'un alliage de fer et de nickel.

Le noyau 10 présente la forme d'un parallélépipède dont la longueur et la largeur sont très supérieures à son épaisseur. Par exemple, le noyau 10 présente une largeur dans la direction Y de 200 µm et une longueur dans la direction X d'environ 1 mm. L'épaisseur du noyau 10 dans la direction Z est par exemple de l'ordre de 2 µm.

Conformément au principe de fonctionnement d'un magnétomètre à porte de flux, le noyau 10 est entouré d'une bobine 12 d'excitation et d'une bobine 14 de mesure. L'une des extrémités de la bobine 12 est raccordée à une source commandable 16 de courant. Le nombre de spires de la bobine 12 est suffisamment important pour générer un champ magnétique d'excitation Bₑₓₓ₁ capable de saturer magnétiquement le noyau 10 lorsqu'elle est parcourue par un courant d'excitation faible. Par courant faible, on désigne un courant dont l'intensité est inférieure à quelques centaines de milliampère et, par exemple, inférieure à 100 mA.

La bobine 14 est enroulée autour du noyau 10 de manière à générer entre ses bornes une différence de potentiels représentative de l'amplitude du champ magnétique Bₘₓ₁ dans le noyau 10. Le champ Bₘₓ₁ est le résultat de la combinaison à l'intérieur du noyau 10 :
- du champ magnétique d'excitation Bₑₓₓ₁ généré par la bobine 12, et
- de la composante Bₜₓ.

Dans la suite de cette description, on adopte la convention de signe suivante : les composantes de champ magnétique dirigée dans le même sens que l'une des directions X, Y ou Z sont positives.

Avec cette convention de signe, le champ magnétique Bₘₓ₁ est donné par la relation suivante : Bₘₓ₁ = Bₑₓₓ₁ + Bₜₓ.

Le nombre de spires de la bobine 14 est aussi élevé que possible pour augmenter la sensibilité du magnétomètre. En effet, plus le nombre de spires est important plus la différence de potentiels apparaissant aux bornes de cette bobine est importante. Ainsi, le nombre de spires des bobines de mesure est ici choisi supérieur à trois et, de préférence, supérieur à dix ou vingt.

La paire de mesures de la composante Bₜₓ comporte également un autre noyau magnétique 18 utilisé pour augmenter la sensibilité de la mesure et pour rejeter le champ magnétique d'excitation Bₑₓₓ₁ des mesures réalisées par la bobine 14. A cet effet, le noyau 18 est par exemple identique au noyau 10 et s'étend donc parallèlement à la direction X. Une bobine 20 d'excitation et une bobine 22 de mesure sont également enroulées autour de ce noyau 18. Par exemple, la bobine 20 est identique à la bobine 12 à l'exception du fait qu'elle est enroulée en sens inverse autour du noyau 18 par rapport au sens d'enroulement de la bobine 12 autour du noyau 10.

De façon similaire, la bobine 22 est identique à la bobine 14.

Ici, les bobines 20 et 12 sont raccordées en série entre des bornes d'alimentation de la source 16. Ainsi, elles sont chacune parcourues par un courant d'excitation de même intensité. Dans ces conditions, les champs magnétiques Bₑₓₓ₁ et Bₑₓₓ₂ sont égaux mais de direction opposée. Dans la suite de cette description, on note donc Bₑₓₓ l'amplitude des champs magnétiques Bₑₓₓ₁ et Bₑₓₓ₂.

La bobine 22 mesure donc un champ magnétique Bₘₓ₂ défini par la relation suivante : Bₘₓ₂ = Bₜₓ - Bₑₓₓ. Avec les mêmes notations, le champ magnétique mesuré par la bobine 14 est défini par la relation : Bₘₓ₁ = Bₜₓ + Bₑₓₓ.

Ici, pour rejeter le champ magnétique d'excitation Bₑₓₓ de la mesure des bobines 14 et 22, celles-ci sont électriquement raccordées en série entre des bornes de mesure d'une unité électronique 26 de traitement de ces mesures.

Dans cette description par « rejeter » ou « réjection » d'une composante ou d'un champ magnétique B, on désigne l'opération consistant à diminuer et, de préférence à rendre négligeable ou à éliminer totalement, cette composante ou ce champ magnétique B devant la ou les autres composantes mesurées par le ou les bobines de mesure.

A cet effet, le raccordement en série est ici réalisé de manière à sommer les champs magnétiques Bₘₓ₁ et Bₘₓ₂. La différence de potentiels traitée par l'unité 26 est alors directement proportionnelle à 2*Bₜₓ. Ce raccordement en série permet également d'augmenter la sensibilité du magnétomètre.

La paire de mesures de la composante B_{ty} est identique à la paire de mesure de la composante Bₜₓ sauf que les noyaux magnétiques sont parallèle à la direction Y. Plus précisément, cette paire comporte :
- deux noyaux magnétiques 28 et 30 parallèles à la direction Y pour canaliser et concentrer le flux magnétique de la composante B_{ty}
- des bobines d'excitation 32, 34, et
- des bobines de mesure 36, 38.

Ici, les noyaux 28 et 30 et les bobines 32, 34, 36 et 38 sont identiques aux noyaux et aux bobines d'excitation et de mesure de la paire de mesure de la composante Bₜₓ. Ainsi, cet agencement permet également de mesurer la composante B_{ty} selon le principe d'un magnétomètre à porte de flux.

La paire de mesure de la composante B_{tz} comprend également deux noyaux magnétiques 36 et 38 destinés à canaliser et à concentrer la composante B_{tz}.

Ces noyaux magnétiques 36 et 38 sont représentés plus en détail sur les figures 2 et 3.

Le noyau 36 comprend un segment horizontal 40 (figures 2 et 3) s'étendant uniquement dans le plan XY parallèlement à la direction Y.

Par exemple, ce segment 40 est identique au noyau 28. Ici, ce segment 40 présente donc une largeur Lₓ de 200 µm dans la direction X, une longueur L_{y} de 988 µm dans la direction Y et une épaisseur e dans la direction Z de 2 µm. Ce segment 40 est réalisé dans le même matériau ferromagnétique que celui utilisé pour réaliser le noyau 10.

En plus du segment horizontal 40, le noyau 36 comporte plusieurs segments inclinés 42A et 42B (figures 2 et 3). Ces segments 42A et 42B s'étendent en dehors du plan XY pour canaliser et concentrer au moins une partie du flux magnétique de la composante B_{tz} vers le segment horizontal 40. Dans ce mode de réalisation, chaque segment 42A, 42B forme une ailette rectangulaire s'étendant uniquement dans le plan ZX perpendiculairement à la direction Y. Ces segments inclinés 42A et 42B sont donc décrits ici dans le cas particulier où ils s'étendent parallèlement à la direction Z. Dans ce cas particulier, ces segments 42A et 42B peuvent aussi être appelés « segments verticaux ».

Ici, ces segments 42A et 42B sont dépourvus de bobinage, c'est-à-dire qu'il n'existe pas une spire d'une bobine d'excitation ou d'une bobine de mesure enroulée autour de ces segments 42A et 42B.

De préférence, le nombre de segments 42A et 42B est élevé, c'est-à-dire supérieure à 10, 20 ou 50 segments. Pour simplifier les figures 1 à 3, seuls un nombre limité de ces segments 42A et 42B a été représenté sur ces figures.

Dans ce mode de réalisation, ces segments 42A et 42B sont répartis à intervalle régulier sur toute la longueur du segment horizontal 40. Par exemple, le noyau 36 comporte 38 segments 42A et 42B espacés les uns des autres par des intervalles de 26 µm.

De préférence, la hauteur H_{z} de chacun de ces segments 42A et 42B est grande devant l'épaisseur e du segment 40, c'est-à-dire au moins trois ou dix fois supérieures à l'épaisseur e. Par exemple, de préférence, la hauteur H_{z} est supérieure à 20 ou 35 µm.

Ces segments 42A et 42B présentent un facteur de forme élevé. Le facteur de forme est ici défini par le rapport de la hauteur H_{z} sur l'épaisseur eₛ de chaque segment. On considère que le facteur de forme est élevé si celui-ci est supérieur à cinq ou six. Par exemple, dans le cas particulier décrit ici, la hauteur H_{z} est égale à 30 µm et l'épaisseur es de chaque segment 42A ou 42B est égale à 5 µm.

Chaque segment s'étend dans le plan XZ sur toute la largeur Lₓ du segment horizontal 40.

Chacun de ces segments est directement magnétiquement raccordé au segment horizontal 40.

Ici, les segments 42A sont inclinés vers le bas tandis que les segments 42B sont inclinés vers le haut. Plus précisément, la moitié des segments est inclinée vers le bas et l'autre moitié est inclinée vers le haut. De plus, tous les segments 42A sont regroupés d'un même côté du segment horizontal 40 tandis que tous les segments 42B sont regroupés de l'autre côté.

A titre d'illustration, des lignes de champ 46 de la composante B_{tz} à l'intérieur du noyau 36 sont représentées sur la figure 2. Comme le montre cette figure, la composante B_{tz} est bien ramenée dans le segment horizontal du noyau.

Le noyau 38 est identique au noyau 36 à l'exception du fait que les segments inclinés sont disposés de manière à ce que le flux magnétique de la composante B_{tz} soit dirigé en sens opposé de la direction de ce flux dans le noyau 36. A cet effet, les segments inclinés 42A et 42B sont remplacés par des segments inclinés 48A et 48B.

Ces segments 48A et 48B sont identiques, respectivement, au segment 42A et 42B sauf qu'ils sont inclinés dans des directions opposées. Ainsi, les segments 48A sont inclinés vers le haut tandis que les segments 48B sont inclinés vers le bas.

Des bobines d'excitation 50, 52 sont uniquement enroulées autour du segment horizontal 40, respectivement, des noyaux 36 et 38. Ces bobines d'excitation 50 et 52 sont identiques et enroulées dans le même sens autour des segments 40 respectifs. De plus, elles sont raccordées en série l'une avec l'autre entre des bornes d'alimentation de la source 16. Ainsi, les champs magnétiques d'excitation B_{exz} générés à l'intérieur des segments horizontaux 40 des noyaux 36 et 38 sont égaux et de même direction.

Des bobines de mesure 54 et 56 sont également enroulées uniquement autour des segments 40, respectivement, des noyaux 36 et 38. Ici, ces bobines 54 et 56 sont identiques et enroulées dans le même sens autour des segments horizontaux 40 respectifs. Elles présentent chacune un nombre de spires élevé de manière à accroître la sensibilité du magnétomètre.

Dans ces conditions, la bobine 54 mesure un champ magnétique B_{mz1} défini par la relation suivante :B_{mz1} = B_{tz} + B_{ty} + B_{exz}.

De façon similaire, la bobine 56 mesure un champ magnétique B_{mz2} défini par la relation suivante : B_{mz2} = -B_{tz} + B_{ty} + B_{exz}.

Ici, les bobines 54 et 56 sont raccordées électriquement en série entre des bornes de l'unité 26 de traitement de manière à soustraire les champs magnétiques B_{mz1} et B_{mz2} mesurés. Ainsi, la différence de potentiels entre ces bornes de l'unité 26 est proportionnelle à 2*B_{tz} puisque la différence des champs B_{mz1} et B_{mz2} permet de rejeter non seulement le champ magnétique d'excitation B_{exz} mais également la composante B_{ty}. Ainsi, cette réjection de la composante B_{ty} est ici réalisée sans qu'aucun traitement électronique particulier ne soit mis en oeuvre.

La figure 4 illustre plus en détail le sens d'enroulement des bobines de mesure et d'excitation. Pour simplifier cette figure, seul un segment 42A, 42B, 48A et 48B a été représenté pour chaque noyau 36, 38.

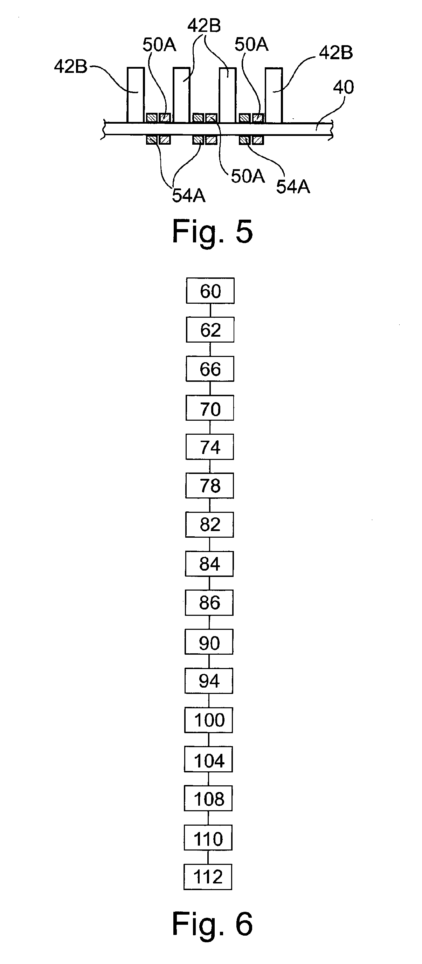

De préférence, les spires des bobines d'excitation et de mesure s'étendent sur toute la longueur du segment 40 contrairement à ce qui est représenté sur la figure 4. Par exemple, à cet effet, comme représenté sur la figure 5, entre chaque segment incliné du noyau est logée une spire 50A de la bobine d'excitation et une spire 54A de la bobine de mesure.

La source 16 est par exemple une source commandable de courant alternatif. L'intensité du courant d'excitation est suffisante pour saturer périodiquement les noyaux magnétiques à l'aide des bobines d'excitation alimentées par cette source. Par exemple, ici, la forme d'onde du courant alternatif est sinusoïdale et sa fréquence est supérieure à 100 kHz et, de préférence, supérieure à 500 kHz. Par exemple, l'amplitude du courant d'excitation est supérieure à 10 ou 20 mA.

L'unité 26 traite les différences de potentiels présentent entre les extrémités des bobines de mesure pour en déduire l'amplitude des composantes Bₜₓ, B_{ty} et B_{tz}. A cet effet, ici, l'unité 26 met en oeuvre un procédé de détection, par exemple, une détection synchrone. Elle commande donc la source 16 de courant de manière à moduler l'intensité du courant d'excitation avec un signal de modulation et démodule les mesures des champs magnétiques à l'aide de ce signal. Par exemple, l'unité 26 est réalisée à partir de trois circuits intégrés autonomes aptes à mesurer, chacun, une seule des composantes Bₜₓ, B_{ty} et B_{tz}. Par exemple, ces circuits intégrés sont des circuits ASIC (Application-Specific Integrated Circuit). De préférence, l'unité 26 est directement fabriquée sur le substrat 6.

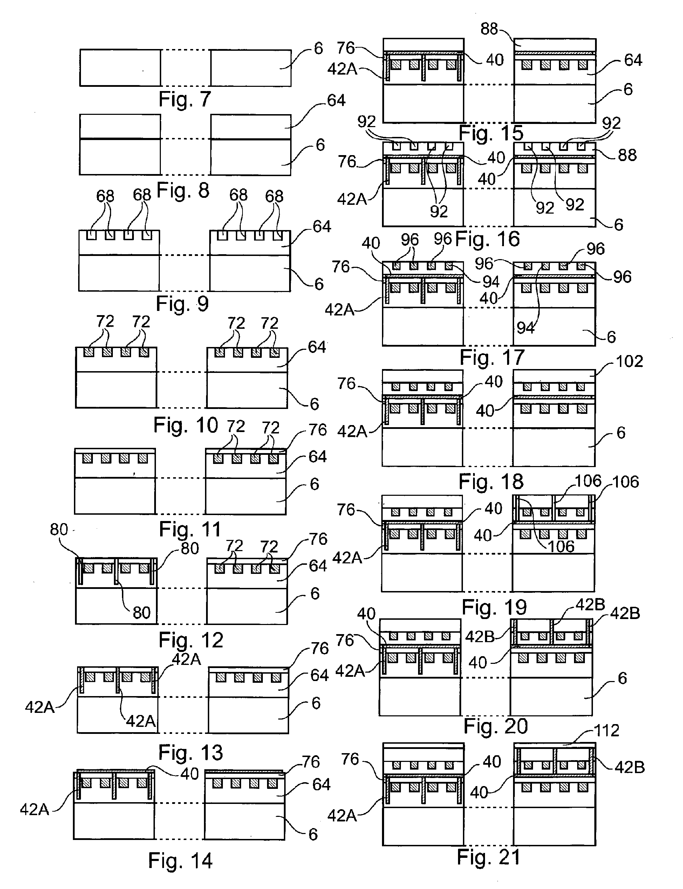

Un exemple de procédé de fabrication du magnétomètre 2 va maintenant être décrit. Pour simplifier cette description, seule la fabrication du noyau 36 et des bobines 50 et 54 est décrite en détail. Les étapes de ce procédé de fabrication sont illustrées sur les figures 7 à 21. Sur les figures 7 à 21, des lignes en pointillée ont été introduites pour indiquer que seules les extrémités de gauche et de droite du noyau magnétique fabriqué ont été représentées. Le procédé de fabrication décrit est un procédé collectif de fabrication microélectronique comportant notamment des étapes de dépôt, de photolithographie, de gravure....

La fabrication de l'unité 26 sur le substrat 6 n'est pas décrite. Par exemple, elle a lieu avant la fabrication des noyaux magnétiques et des bobines.

Initialement, lors d'une étape 60 (figure 7), le substrat 6 est fourni. Par exemple, il s'agit d'un substrat en silicium. On suppose ici que ce substrat incorpore déjà l'unité 26 de traitement et, éventuellement, la source 16.

Ensuite, lors d'une étape 62 (figure 8), une couche 64 en matériau électriquement isolant est déposée sur une face supérieure du substrat 6. Par exemple, cette couche est une couche en oxyde de silicium (par exemple SiO₂).

Lors d'une étape 66 (figure 9), la couche 64 est gravée pour former des logements 68 pour recevoir une partie inférieure des spires 50A et 54B des bobines 50 et 54.

Lors d'une étape 70 (figure 10), un métal conducteur est déposé dans les logements 68 pour former la partie inférieure 72 des spires 50A et 54A des bobines 50 et 54. Par exemple, ce métal est du cuivre. Par exemple, le dépôt est fait par électrolyse ou dépôt PVD (Physical Vapor Deposition) puis planarisation mécano-chimique.

Lors d'une étape 74 (figure 11), une nouvelle couche 76 en matériau électriquement isolant est déposée sur la face supérieure (par exemple du SiO₂).

Lors d'une étape 78 (figure 12), des logements 80 sont gravés pour recevoir les segments 42A uniquement dans la partie gauche du noyau en cours de fabrication. Ici, les logements 80 s'enfoncent entre les parties inférieures 72 des spires des bobines 50 et 54.

Lors d'une étape 82 (figure 13), un matériau ferromagnétique est déposé à l'intérieur des logements 80 pour former les segments 42A. Ici, le matériau ferromagnétique déposé est un alliage de fer et de nickel (FeNi). Par exemple, le dépôt est fait par électrolyse ou dépôt PVD.

Lors d'une étape 84 (figure 14), une couche en matériau ferromagnétique est déposée sur la face supérieure puis gravée pour former le segment 40. Cette étape peut n'être que le prolongement de l'étape précédente.

Lors d'une étape 86 (figure 15), une nouvelle couche 88 du matériau électriquement isolant est déposée.

Lors d'une étape 90 (figure 16), cette couche 88 est gravée pour former des logements 92 destinés à recevoir la partie supérieure des spires des bobines 50 et 54.

Lors de l'étape 90, les couches 88 et 76 sont également gravées pour former des puits verticaux destinés à recevoir des picots conducteurs raccordant électriquement les parties supérieure et inférieure des spires. Ces puits ne sont pas représentés sur la figure 16.

Lors d'une étape 94 (figure 17), un métal conducteur, ici du cuivre, est déposé dans les logements 92 pour former une partie supérieure 96 des bobines 50 et 54.

Lors de l'étape 94, les puits verticaux reliant les parties inférieures et supérieures des spires sont également remplis du métal conducteur afin de former les picots conducteurs. Ces picots ne sont pas représentés sur les figures 17 à 21.

Lors d'une étape 100 (figure 18), une nouvelle couche 102 du matériau électriquement isolant est déposée sur la face supérieure.

Lors d'une étape 104 (figure 19), les couches 102 et 88 sont gravées pour former des logements 106 destinés à recevoir les segments 42B.

Lors d'une étape 108 (figure 20), le matériau ferromagnétique est déposé à l'intérieur des logements 106 pour former les segments 42B.

Lors d'une étape 110 (figure 21), une nouvelle couche 112 du matériau électriquement isolant est déposée sur la face supérieure.

Enfin, lors d'une étape 112, le substrat est découpé pour séparer mécaniquement les différents magnétomètres simultanément fabriqués sur le même substrat lors des étapes précédentes.

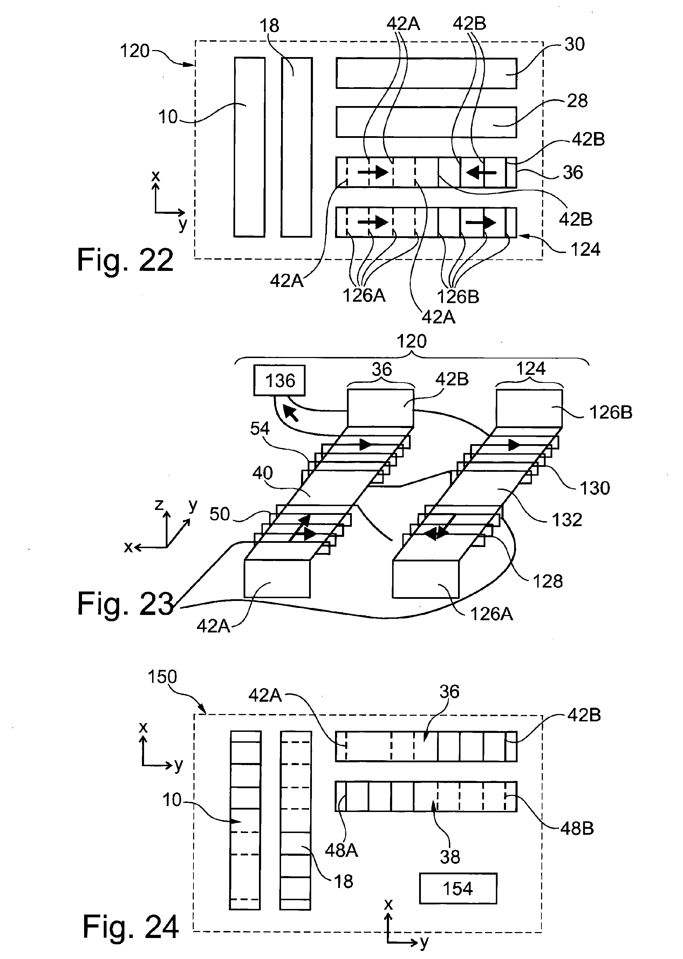

Les figures 22 et 23 représentent un magnétomètre 120 identique au magnétomètre 2 à l'exception que le noyau 38 est remplacé par un noyau 124. Le noyau 124 s'étend parallèlement au noyau 36 le long de la direction Y. Ce noyau 124 est par exemple identique en tout point au noyau 36. Ainsi, contrairement au magnétomètre 2, le sens de circulation du flux magnétique de la composante B_{tz} dans le noyau 124 est le même que dans le noyau 36.

Sur la figure 22 et les figures suivantes, les segments 42A inclinés vers le bas sont représentés par une ligne en pointillée tandis que les segments 42B inclinés vers le haut sont représentés par une ligne en trait plein. Les segments verticaux inclinés vers le bas et vers le haut du noyau 124 portent, respectivement, les références 126A et 126B.

Sur la figure 23, un seul segment 42A, 42B, 126A ou 126B est représenté pour chaque noyau 36, 124.

Une bobine d'excitation 128 et une bobine de mesure 130 sont enroulées uniquement autour d'un segment horizontal 132 (figure 23) du noyau 124.

La bobine 128 est identique à la bobine 50 et enroulée autour du segment 132 dans le même sens que la bobine 50 autour du segment 40. De même, les bobines 54 et 130 sont enroulées dans le même sens autour, respectivement, des segments horizontaux 40 et 132. Les bobines 50 et 128 sont raccordées en série entre les bornes de la source de courant 16 de manière à ce que le champ magnétique d'excitation généré dans le segment 132 soit égal mais de sens opposé à celui généré dans le segment 40.

Dans ces conditions, le champ magnétique B_{mz1} mesuré par la bobine 54 est défini par la relation suivante : B_{mz1} = B_{tz} + B_{ty} + B_{exz}.

Le champ magnétique B_{mz2} mesuré par la bobine 130 est quant à lui défini par la relation suivante : B_{mz2} = B_{tz} + B_{ty} - B_{exz}

Pour rejeter le champ magnétique d'excitation B_{exz}, les bobines 54 et 130 sont raccordées en série de manière à ce que le champ magnétique mesuré B_{mz1} et B_{mz2} s'additionnent.

La différence de potentiel entre les extrémités des bobines 54 et 130 raccordées en série est donc proportionnelle à 2*B_{tz} + 2*B_{ty}. On constate donc que dans ce mode de réalisation, le raccordement en série des bobines de mesure 54 et 130 ne permet pas de rejeter la composante B_{ty}.

Pour rejeter la composante B_{ty}, l'unité 126 de traitement est remplacée par une unité 136 (figure 23) de traitement. L'unité 136 rejette la composante B_{ty} à partir de la mesure de cette composante B_{ty} réalisée à l'aide des noyaux 28 et 30.

Par exemple, cette unité 136 injecte un courant I_{CR} de contre réaction dans les bobines 54 et 130 pour générer un champ magnétique qui annule la composante B_{ty} à l'intérieur des noyaux 36 et 124. Ici, l'intensité du courant I_{CR} est obtenue à partir des mesures de la composante B_{ty} réalisée à l'aide des noyaux 28 et 30. Par exemple, une contre-réaction en champ magnétique est mise en oeuvre pour mesurer la composante B_{ty} dans les noyaux 28 et 30. Cette contre réaction consiste à mesurer la différence entre le champ magnétique mesuré par les bobines 32 et 34 et zéro puis à injecter dans les bobines 32 et 34 le courant I_{CR} dont l'intensité est calculée pour annuler cette différence. Ainsi, l'intensité de ce courant I_{CR} injecté dans les bobines 32 et 34 est représentative de l'amplitude de la composante B_{ty}. Ici ce courant I_{CR} de contre-réaction est également injecté dans les bobines 54 et 130 de manière à annuler la composante B_{ty} dans les noyaux 36 et 124 ce qui permet de mesurer la composante B_{tz}.

La mise en oeuvre d'une contre-réaction en champ magnétique permet de mesurer des champs magnétiques importants c'est-à-dire dont l'intensité est supérieure à 50 ou 100 µT tout en conservant une bonne linéarité.

La figure 24 représente un magnétomètre 150 qui permet de mesurer en alternance, la composante B_{tz} et la composante B_{ty} en utilisant les mêmes noyaux magnétiques 36 et 38. Par exemple, le magnétomètre 150 est identique au magnétomètre 2 à l'exception du fait que les noyaux 28 et 30 sont omis ainsi que les différents bobinages entourant ces noyaux.

Pour arriver à ce résultat, deux solutions sont décrites ici. La première solution consiste à raccorder individuellement les bobines 50 et 52 entre des bornes respectives de la source 16 et les bobines 54 et 56 entre des bornes respectives d'une unité de traitement 154 qui remplace l'unité 26.

Pour mesurer la composante B_{ty}, l'unité 154 commande la source 16 de courant pour faire circuler le courant en sens opposé dans les bobines d'excitation 50 et 52. Ainsi, les flux du champ magnétique d'excitation à l'intérieur des noyaux 36 et 38 sont en sens opposé. Dans ces conditions, le champ magnétique B_{mz1} mesuré par la bobine 54 est défini par la relation suivante : B_{mz1} = -B_{exz} + B_{ty} + B_{tz}.

Le champ magnétique B_{mz2} mesuré est quant à lui défini par la relation suivante : B_{mz2} = B_{exz} + B_{ty} - B_{tz}.

Dès lors, pour mesurer la composante B_{ty} et rejeter la composante B_{tz}, l'unité 154 somme les mesures B_{mz1} et B_{mz2} lorsque les champs magnétiques d'excitation sont en sens opposé. Le signal obtenu est alors proportionnel à 2*B_{ty}.

Pour mesurer la composante B_{tz}, l'unité 154 commande la source de courant 16 pour faire circuler le courant d'excitation dans les bobines 50 et 52 dans le même sens. Dans ces conditions de fonctionnement, le champ magnétique B_{mz1} mesuré par la bobine 54 est défini par la relation suivante : B_{mz1} = -B_{exz} + B_{ty} + B_{tz}. Le champ magnétique B_{mz2} mesuré par la bobine 56 est défini par la relation suivante : B_{mz2} = -B_{exz} + B_{ty} - B_{tz}.

Par conséquent, pour mesurer de la composante B_{tz} et rejeter la composante B_{ty}, l'unité 154 soustrait les mesures des champs magnétiques B_{mz1} et B_{mz2}. Cette différence est alors proportionnelle à 2*B_{tz}.

Ainsi l'unité 154 peut mesurer, en alternance, les composantes B_{ty} et B_{tz} en utilisant les mêmes noyaux 36, 38 et les mêmes bobines d'excitation et de mesure.

La seconde solution est basée sur le même principe sauf qu'au lieu d'inverser le sens de circulation du courant d'excitation dans les bobines d'excitation, une bobine d'excitation supplémentaire est ajoutée autour du noyau 38. Cette bobine d'excitation supplémentaire est identique à la bobine 52 à l'exception du fait qu'elle est enroulée en sens opposé autour du segment horizontal 40. De même, une bobine de mesure supplémentaire est ajoutée autour du segment 40 du noyau 36. Cette bobine de mesure supplémentaire est identique à la bobine 54 à l'exception du fait qu'elle est bobinée en sens inverse. Le fonctionnement de cette seconde solution est identique à celui décrit pour la première solution à l'exception que pour changer la direction du champ magnétique d'excitation dans l'un des noyaux, on alimente la bobine supplémentaire d'excitation à la place de la bobine 52. De même, pour soustraire les mesures des champs magnétiques mesurés, on utilise la bobine supplémentaire de mesure à la place de la bobine 54.

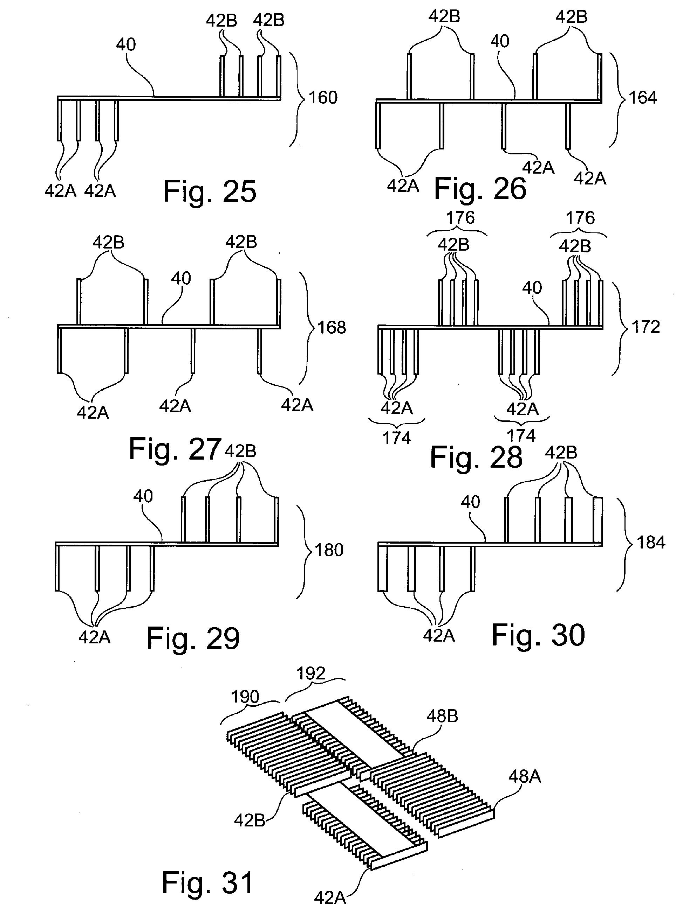

La figure 25 représente un noyau magnétique 160 identique au noyau 36 à l'exception du fait que les segments 42A et 42B ne sont pas répartis avec un pas régulier le long de toute la longueur du segment 40. Plus précisément, le groupe de segments 42A est ici séparé du groupe de segments 42B par un intervalle dont la longueur est bien plus grande que l'intervalle séparant deux segments 42A ou 42B successifs. Cet intervalle plus grand au centre du segment horizontal 40 permet de laisser plus de place pour enrouler les bobines de mesure et d'excitation.

La figure 26 représente un noyau magnétique 164 utilisable à la place du noyau 36. Ce noyau 164 est identique au noyau 36 à l'exception du fait que les segments 42A et 42B sont alternés sur toute la longueur du segment 40. Plus précisément, au milieu de chaque intervalle séparant deux segments successifs 42A est érigé un segment 42B et vice versa.

La figure 27 représente un noyau magnétique 168 utilisable à la place du noyau 36. Ce noyau 168 est identique au noyau 164 à l'exception du fait que les segments 42B ne sont pas situés exactement au milieu de l'intervalle séparant deux segments successifs 42A.

La figure 28 représente un noyau magnétique 172 utilisable à la place du noyau 36. Ce noyau 172 est identique au noyau 36 à l'exception du fait que les segments 42A sont divisés en plusieurs groupes 174 séparés par un intervalle au milieu duquel est érigé un groupe 176 de segments 42B. Ici, tous les groupes de segments 174 contiennent le même nombre de segments 42A. De façon similaire, tous les groupes 176 contiennent exactement le même nombre de segments 42B. Ici, les groupes 174 et 176 contiennent les mêmes nombres de segments.

La figure 29 représente un noyau 180 utilisable à la place du noyau 36. Ce noyau 180 est identique au noyau 36 à l'exception du fait que le pas qui sépare les différents segments 42A et 42B n'est pas régulier. Par exemple, le pas augmente au fur et mesure que l'on se rapproche de l'une des extrémités du segment horizontal.

La figure 30 représente un noyau 184 utilisable à la place du noyau 36. Ce noyau 184 est identique au noyau 36 à l'exception du fait que les épaisseurs es des segments 42A et 42B ne sont pas constantes. Par exemple, l'épaisseur des segments 42A et 42B va en augmentant au fur et à mesure que l'on se rapproche de l'une des extrémités du segment horizontal 40.

La figure 31 représente deux noyaux magnétiques 190 et 192 utilisables à la place, respectivement, des noyaux 36 et 38. Ici, ces noyaux 190 et 192 sont, respectivement, identiques au noyau 36 et 38 à l'exception du fait que la largeur des segments 42A, 42B, 48A et 48B est supérieure à la largeur du segment horizontal 40 dans la direction X. Cette configuration permet d'améliorer la sensibilité du magnétomètre en augmentant l'intensité du flux magnétique de la composante B_{tz} dans le segment horizontal 40.

De nombreux autres modes de réalisation sont possibles. Par exemple, les noyaux magnétiques peuvent être formés de plusieurs aiguilles magnétiques parallèles les unes aux autres ce qui réduit la quantité de matériau magnétique et permet de réduire l'intensité du champ démagnétisant.

Un seul noyau magnétique peut être suffisant pour mesurer la composante B_{tz} si l'on dispose d'autres moyens pour rejeter la composante B_{ty}. Par exemple, si la composante B_{ty} est mesurée par un autre magnétomètre, il n'est pas nécessaire de disposer d'un second noyau magnétique parallèle au premier pour rejeter cette composante B_{ty} du signal mesuré.

Les segments inclinés 48A et 48B présents sur le second noyau magnétique utilisé pour rejeter la composante B_{ty} peuvent être omis. Ceci s'applique à tous les modes de réalisation décrits.

Il n'est pas nécessaire que le segment horizontal du noyau magnétique utilisé pour rejeter la composante B_{ty} soit parallèle au noyau magnétique utilisé pour mesurer la composante B_{tz}. Par exemple, il suffit que ce noyau soit légèrement incliné par rapport à la direction X pour que celui-ci soit sensible à la composante B_{ty} ce qui permet de rejeter, au moins en partie, la composante B_{ty} des mesures de la composante B_{tz}.

De préférence, le nombre de segments inclinés est important. Toutefois, celui-ci peut être réduit et, à la limite, un seul segment incliné sur un seul noyau permet de mesurer la composante B_{tz}.

Les segments inclinés ne sont pas nécessairement parallèles à la direction Z. Par exemple, ils peuvent faire un angle θ non nul avec cette direction Z. Toutefois, θ sera alors dans ce cas différent de 90° et, de préférence, inférieur à 45°.

La forme des segments inclinés n'est pas nécessairement parallélépipédique. Par exemple, les segments inclinés peuvent être remplacés par des plots ou des picots de section transversale circulaire ou autres permettant de canaliser la composante B_{tz} vers le segment horizontal. De façon similaire, il n'est pas nécessaire que le segment horizontal soit un parallélépipède. D'autres sections transversales pour ce segment horizontal sont possibles.

Dans un autre mode de réalisation, les segments inclinés ne sont pas disposés dans un plan perpendiculaire à la direction Y mais au contraire, par exemple, perpendiculaire à la direction X. D'autres dispositions des plans dans lesquelles s'étendent les segments inclinés sont également possibles.

Il existe également différentes façons de répartir les spires des bobines de mesure et d'excitation le long du segment horizontal. Par exemple, les spires des bobines d'excitation et de mesure peuvent être entrelacées ou non. Elles peuvent être bobinées avec un pas constant ou non et le pas de bobinage des bobines d'excitation et de mesure peuvent être identique ou non.

Dans un autre mode de réalisation, quelques spires de la bobine d'excitation ou de la bobine de mesure peuvent être enroulées autour du segment incliné. Toutefois, même dans ce mode de réalisation, de préférence, la majorité des spires et enroulée autour du segment horizontal.

De préférence, le bobinage des bobines est optimisé en fonction de la forme du noyau retenue. Par exemple, la densité de spires de la bobine de mesure est augmenté autour de la zone du noyau correspondant au maximum du champ B_{zt.} pour accroître la sensibilité du dispositif. Par « densité de la bobine », on désigne le nombre de spires de la bobine par unité de longueur du noyau autour duquel elles sont enroulées. Dans les autres zones du noyau, cette densité est réduite. Ainsi, dans ces autres zones, la densité de la bobine d'excitation peut être augmentée pour réduire la consommation du magnétomètre. Par exemple pour le noyau 168 de la figure 27, la densité de la bobine de mesure est supérieure dans la zone la plus « courte » du segment horizontal 40 comprise entre deux segments inclinés immédiatement successifs 42A, 42B que dans la zone la plus « longue » entre ce même segment 42A et l'autre segment 42B immédiatement successif situé du côté opposé. La densité de la bobine de mesure est réduite ailleurs que dans la zone la plus courte. Ceci permet, par exemple, d'augmenter dans les zones les plus « longues », la densité de la bobine d'excitation.

Il n'est pas nécessaire de disposer de segment incliné dans des directions opposées. Par exemple, tous les segments inclinés d'un même noyau peuvent être inclinés dans la même direction. Il n'est d'ailleurs pas nécessaire que ces directions d'inclinaison soient parallèle les unes aux autres.

Des segments inclinés peuvent être prévus aussi bien sur les segments horizontaux qui s'étendent parallèlement à la direction Y qu'à la direction X. Par exemple, c'est ce qui a été représenté sur la figure 24 où les noyaux 10 et 18 sont pourvus de segments inclinés représentés par des lignes en traits pointillée lorsqu'ils sont dirigés vers le bas et par des lignes en trait plein lorsqu'ils sont dirigés vers le haut.

## Revendications

1. Magnétomètre à porte de flux pour mesurer une composante B_{tz} d'un champ magnétique le long d'une direction Z, ce magnétomètre comportant :
- un substrat (6) s'étendant essentiellement parallèlement à un plan XY parallèle à des directions X et Y horizontales et perpendiculaire à la direction Z,
- un premier noyau magnétique (36), fabriqué sur le substrat (6), présentant un segment horizontal (40) s'étendant parallèlement à la direction Y pour canaliser une composante B_{ty} du champ magnétique,
- une première bobine d'excitation (50) et une première bobine de mesure (54) enroulées autour du segment horizontal pour mesurer l'intensité du champ magnétique dans ce segment horizontal,
**caractérisé en ce que** le premier noyau (36) présente également au moins un premier segment incliné (42A, 42B) s'étendant dans une direction en dehors du plan XY et apte à diriger au moins une partie du flux magnétique de la composante B_{tz} vers le segment horizontal.

2. Magnétomètre selon la revendication 1, dans lequel le magnétomètre comprend des moyens de réjection de la composante B_{ty} de la mesure réalisée par la première bobine de mesure.

3. Magnétomètre selon la revendication 2, dans lequel les moyens de réjection comprennent :
- au moins un deuxième noyau magnétique (38; 124) apte à canaliser lui aussi la composante B_{ty}, et
- des deuxièmes bobines d'excitation (52) et de mesure (56) enroulées autour du deuxième noyau pour mesurer la composante B_{ty} à rejeter de la mesure réalisée avec la première bobine de mesure.

4. Magnétomètre selon la revendication 3, dans lequel le deuxième noyau (38; 124) présente également au moins un premier segment incliné (48A, 48B; 126A, 126B) s'étendant dans une direction en dehors du plan XY.

5. Magnétomètre selon la revendication 4, dans lequel ledit au moins un premier segment incliné (48A, 48B) du deuxième noyau (38) est apte à diriger le flux de la composante B_{tz} vers le segment horizontal de ce deuxième noyau dans une direction opposée à la direction du flux de la composante B_{tz} dans le segment horizontal du premier noyau (36).

6. Magnétomètre selon la revendication 5, dans lequel les moyens de réjection comprennent une unité électronique (154) de traitement apte :
- à additionner et, en alternance, à soustraire électroniquement l'une à l'autre les mesures des première et deuxième bobines de mesure de manière à rejeter, en alternance, la composante B_{ty} et la composante B_{tz} pour mesurer, à partir des mêmes noyaux (36, 38) et à l'aide des mêmes bobines, soit la composante B_{tz} soit la composante B_{ty}, et
- à commander une source (16) de courant alimentant la première ou la deuxième bobines d'excitation de manière à inverser la direction du champ magnétique d'excitation dans un seul des segments horizontaux des premier et deuxième noyaux magnétiques (36, 38) pour rejeter également le champ magnétique d'excitation aussi bien lorsque les mesures des première et deuxième bobines sont additionnées que soustraites.

7. Magnétomètre selon la revendication 5, dans lequel le magnétomètre comporte :
- une troisième bobine de mesure enroulée en sens inverse de la première bobine de mesure autour du segment horizontal du premier noyau,
- une troisième bobine d'excitation enroulée en sens inverse de la deuxième bobine d'excitation du segment horizontal du deuxième noyau, et
- une unité électronique de traitement apte :
• à additionner, en alternance, les mesures des première et deuxième bobines de mesure et les mesures des première et troisième bobines de mesure de manière à rejeter, en alternance, la composante B_{tz} et la composante B_{tz} pour mesurer, à partir des mêmes noyaux, soit la composante B_{tz} soit la composante B_{ty}, et
• à commander l'alimentation, en alternance, des première et deuxième bobines d'excitation et des première et troisième bobines d'excitation de manière à inverser la direction du champ magnétique d'excitation dans un seul des segments horizontaux pour rejeter également le champ magnétique d'excitation aussi bien lorsque les mesures des première et deuxième bobines de mesure et les mesures des première et troisième bobines de mesure sont additionnées.

8. Magnétomètre selon la revendication 5, dans lequel les première et deuxième bobines de mesure (54, 56) sont raccordées électriquement en série de manière à soustraire l'une à l'autre les composantes B_{ty} canalisées, respectivement, par les premier et deuxième noyaux (36, 38).

9. Magnétomètre selon l'une quelconque des revendications précédentes, dans lequel chaque noyau comprend au moins un deuxième segment incliné (42B, 48B; 126B) dirigé dans une direction opposée à celle du premier segment incliné (42A, 48A; 126A), tous les segments inclinés dirigés dans une même direction étant regroupés d'un même côté du segment horizontal (40; 132) et tous les segments inclinés dirigés dans la direction opposée étant regroupés d'un autre côté du segment horizontal.

10. Magnétomètre selon l'une quelconque des revendications précédentes, dans lequel chaque noyau comprend plus de dix segments inclinés.

11. Magnétomètre selon l'une quelconque des revendications précédentes, dans lequel le magnétomètre comprend :
- au moins un noyau magnétique supplémentaire (10, 18) présentant un segment horizontal s'étendant parallèlement au plan XY dans une direction sécante avec la direction Y pour canaliser également une composante Bₜₓ du champ magnétique mesuré le long de la direction X, et
- des bobines d'excitation (12, 20) et de mesure (14, 22) enroulées autour de ce segment horizontal supplémentaire pour mesurer la composante Bₜₓ.

12. Procédé de fabrication d'un magnétomètre à porte de flux pour mesurer une composante B_{tz} d'un champ magnétique le long d'une direction Z, ce procédé comportant :
- la fourniture (60) d'un substrat s'étendant essentiellement parallèlement à un plan XY parallèle à des directions X et Y horizontales et perpendiculaire à la direction Z,
- le dépôt et/ou la gravure (84), sur le substrat, d'un segment horizontal d'un noyau magnétique, ce segment horizontal s'étendant parallèlement à la direction Y pour canaliser une composante B_{ty} du champ magnétique,
- le dépôt et/ou la gravure (66, 70, 90, 94) d'une bobine d'excitation et d'une bobine de mesure enroulées autour du segment horizontal pour mesurer l'intensité du champ magnétique dans ce segment horizontal,
**caractérisé en ce que** le procédé comprend également le dépôt et/ou la gravure (78, 82, 104, 108) d'un segment incliné du noyau, ce segment incliné s'étendant dans une direction en dehors du plan XY et étant apte à diriger au moins une partie du flux magnétique de la composante B_{tz} vers le segment horizontal.

## Patentansprüche

1. Fluxgate-Magnetometer, um eine Komponente B_{tz} eines Magnetfeldes entlang einer Richtung Z zu messen, wobei dieses Magnetometer umfasst:
- ein Substrat (6), das sich im Wesentlichen parallel zu einer Ebene XY parallel zu den horizontalen Richtungen X und Y und senkrecht auf die Richtung Z erstreckt,
- einen ersten Magnetkern (36), der auf dem Substrat (6) hergestellt ist und ein horizontales Segment (40) aufweist, das sich parallel zur Richtung Y erstreckt, um eine Komponente B_{ty} des Magnetfeldes zu kanalisieren,
- eine erste Erregerspule (50) und eine erste Messspule (54), die um das horizontale Segment gewickelt sind, um die Stärke des Magnetfeldes in diesem horizontalen Segment zu messen,
**dadurch gekennzeichnet, dass** der erste Kern (36) auch mindestens ein erstes geneigtes Segment (42A, 42B) aufweist, das sich in eine Richtung über die Ebene XY hinaus erstreckt und geeignet ist, zumindest einen Teil des Magnetstroms von der Komponente B_{tz} zu dem horizontalen Segment zu lenken.

2. Magnetometer nach Anspruch 1, bei dem das Magnetometer Mittel zur Unterdrückung der Komponente B_{ty} der von der ersten Messspule durchgeführten Messung umfasst.

3. Magnetometer nach Anspruch 2, bei dem die Unterdrückungsmittel umfassen:
- mindestens einen zweiten Magnetkern (38; 124), der geeignet ist, ebenfalls die Komponente B_{ty} zu kanalisieren, und
- zweite Erreger- (52) und Messspulen (56), die um den zweiten Kern gewickelt sind, um die zu unterdrückende Komponente B_{ty} der Messung, die mit der ersten Messspule durchgeführt wurde, zu messen.

4. Magnetometer nach Anspruch 3, bei dem der zweite Kern (38; 124) ebenfalls mindestens ein erstes geneigtes Segment (48A, 48B; 126A, 126B) aufweist, das sich in eine Richtung über die Ebene XY hinaus erstreckt.

5. Magnetometer nach Anspruch 4, bei dem das mindestens eine geneigte Segment (48A, 48B) des zweiten Kerns (38) geeignet ist, den Strom der Komponente B_{tz} zu dem horizontalen Segment dieses zweiten Kerns in eine Richtung zu lenken, die zu der Richtung des Stroms der Komponente B_{tz} in dem horizontalen Segment des zweiten Kerns (36) entgegengesetzt ist.

6. Magnetometer nach Anspruch 5, bei dem die Unterdrückungsmittel eine elektronische Bearbeitungseinheit (154) umfassen, die geeignet ist:
- elektronisch die Messungen der ersten und zweiten Messspule zu addieren und alternierend voneinander zu subtrahieren, um alternierend die Komponente B_{ty} und die Komponente B_{tz} zu unterdrücken, um ausgehend von den Kernen (36, 38) und mit Hilfe derselben Spulen entweder die Komponente B_{tz} oder die Komponente B_{ty} zu messen, und
- eine Stromquelle (16), die die erste oder die zweite Erregerspule versorgt, derart zu steuern, dass die Richtung des Erregermagnetfeldes in einem einzigen der horizontalen Segmente des ersten und zweiten Magnetkerns (36, 38) umgekehrt wird, um ebenfalls das Erregermagnetfeld sowohl wenn die Messungen der ersten und zweiten Spulen addiert, als auch wenn sie subtrahiert werden, zu unterdrücken.

7. Magnetometer nach Anspruch 5, bei dem das Magnetometer umfasst:
- eine dritte Messspule, die in umgekehrte Richtung der ersten Messspule um das horizontale Segment des ersten Kerns gewickelt ist,
- eine dritte Erregerspule, die in umgekehrte Richtung der zweiten Erregerspule des horizontalen Segments des zweiten Kerns gewickelt ist, und
- eine elektronische Bearbeitungseinheit, die geeignet ist:
* alternierend die Messungen der ersten und zweiten Messspulen und die Messungen der ersten und dritten Messspulen zu addieren, um alternierend die Komponente B_{ty} und die Komponente B_{tz} zu unterdrücken, um ausgehend von denselben Kernen entweder die Komponente B_{tz} oder die Komponente B_{ty} zu messen, und
* alternierend die Versorgung der ersten und zweiten Erregerspulen und der ersten und dritten Erregerspulen zu steuern, um die Richtung des Erregermagnetfeldes in einem einzigen der horizontalen Segmente umzukehren, um ebenfalls das Erregermagnetfeld zu unterdrücken, wenn die Messungen der ersten und zweiten Messspulen und die Messungen der ersten und dritten Messspulen addiert werden.

8. Magnetometer nach Anspruch 5, bei dem die erste und die zweite Messspule (54, 56) elektrisch in Serie angeschlossen sind, um die Komponenten B_{ty}, die von dem ersten bzw. dem zweiten Kern (36, 38) kanalisiert werden, voneinander zu subtrahieren.

9. Magnetometer nach einem der vorhergehenden Ansprüche, bei dem jeder Kern mindestens ein zweites geneigtes Segment (42B, 48B; 126B) umfasst, das in eine Richtung gelenkt wird, die zu jener des ersten geneigten Segments (42A, 48A; 126A) entgegengesetzt ist, wobei alle in eine selbe Richtung gelenkten geneigten Segmente auf einer selben Seite des horizontalen Segments (40; 132) zusammengefasst sind, und alle in die entgegengesetzte Richtung gelenkten geneigten Segmente auf einer andere Seite des horizontalen Segments zusammengefasst sind.

10. Magnetometer nach einem der vorhergehenden Ansprüche, bei dem jeder Kern mehr als zehn geneigte Segmente umfasst.

11. Magnetometer nach einem der vorhergehenden Ansprüche, bei dem das Magnetometer umfasst:
- mindestens einen zusätzlichen Magnetkern (10, 18), der ein horizontales Segment aufweist, das sich parallel zu der Ebene XY in eine Richtung erstreckt, die die Richtung Y schneidet, um ebenfalls eine Komponente Bₜₓ des gemessenen Magnetfeldes entlang der Richtung X zu kanalisieren, und
- Erreger- (12, 20) und Messspulen (14, 22), die um dieses zusätzliche horizontale Segment gewickelt sind, um die Komponente Bₜₓ zu messen.

12. Verfahren zur Herstellung eines Fluxgate-Magnetometers zum Messen einer Komponente B_{tz} eines Magnetfeldes entlang einer Richtung Z, wobei das Verfahren umfasst:
- Bereitstellung (60) eines Substrats, das sich im Wesentlichen parallel zu einer Ebene XY parallel zu horizontalen Richtungen X und Y senkrecht auf die Richtung Z erstreckt,
- Aufbringen und/oder Gravieren (84) eines horizontalen Segments eines Magnetkerns auf das Substrat, wobei sich dieses horizontale Segment parallel zu der Richtung Y erstreckt, um eine Komponente B_{ty} des Magnetfeldes zu kanalisieren,
- Aufbringen und/oder Gravieren (66, 70, 90, 94) einer Erregerspule und einer Messspule, die um das horizontale Segment gewickelt sind, um die Stärke des Magnetfeldes in diesem horizontalen Segment zu messen,
**dadurch gekennzeichnet, dass** das Verfahren auch das Aufbringen und/oder Gravieren (78, 82, 104, 108) eines geneigten Segments des Kerns umfasst, wobei sich das geneigte Segment in eine Richtung über die Ebene XY hinaus erstreckt und geeignet ist, mindestens einen Teil des Magnetstroms der Komponente B_{tz} zu dem horizontalen Segment zu lenken.

## Claims

1. A fluxgate magnetometer for measuring a component B_{tz} of a magnetic field along a direction Z, said magnetometer comprising:
- a substrate (6) extending substantially parallel to a plane XY parallel to the horizontal directions X and Y and perpendicular to the direction Z,
- a first magnetic core (36) manufactured on the substrate (6), exhibiting a horizontal segment (40) extending parallel to the direction Y to channel a component B_{ty} of the magnetic field,
- a first excitation coil (50) and a first measuring coil (54) wrapped about the horizontal segment to measure the intensity of the magnetic field in this horizontal segment,
**characterized in that** the first core (36) likewise exhibits at least a first sloping segment (42A, 42B) extending in a direction outside the plane XY and capable of directing at least a fraction of the magnetic flux of the component B_{tz} towards the horizontal segment.

2. The magnetometer according to claim 1, in which the magnetometer comprises means of rejecting the component B_{ty} of the measurement taken by the first measuring coil.

3. The magnetometer according to claim 2, in which the rejection means comprise:
- at least a second magnetic core (38; 124) also capable of channelling the component B_{ty} and
- second excitation (52) and measuring (56) coils wrapped about the second core for measuring the component B_{ty} to be rejected in the measurement taken using the first measuring coil.

4. The magnetometer according to claim 3, in which the second core (38; 124) likewise exhibits at least a first sloping segment (48A, 48B, 126A, 126B) extending in a direction beyond the plane XY.

5. The magnetometer according to claim 4, in which said at least one first sloping segment (48A, 48B) of the second core (38) is capable of directing the flux of the component B_{tz} towards the horizontal segment of this second core in an opposite direction to the direction of the flux of the component B_{tz} in the horizontal segment of the first core (36).

6. The magnetometer according to claim 5, in which the rejection means comprise an electronic processing unit (154) capable of:
- alternately adding and subtracting electronically the measurements from the first and second measuring coils, so as to reject the component B_{ty} and the component B_{tz} alternately, in order to measure either the component B_{tz} or the component B_{ty} from the same cores (36, 38) and with the help of the same coils, and
- controlling a current source (16) supplying the first or second excitation coils, so as to reverse the direction of the excitation magnetic field in only one of the horizontal segments of the first and second magnetic coils (36, 38) likewise to reject the excitation magnetic field when the measurements of the first and second coils are both added and subtracted.

7. The magnetometer according to claim 5, in which the magnetometer comprises:
- a third measuring coil wrapped in a direction counter to the first measuring coil about the horizontal segment of the first core,
- a third excitation coil wrapped in a direction counter to the second excitation coil about the horizontal segment of the second core and
- an electronic processing unit capable of:
□ alternately adding measurements from the first and second measuring coils and measurements from the first and third measurement coils, so as to reject the component B_{ty} and the component B_{tz} alternately, in order to measure either the component B_{tz} or the component B_{ty} from the same cores, and
□ alternately controlling the supply to the first and second excitation coils and the first and third excitation coils, so as to reverse the direction of the excitation magnetic field in only one of the horizontal segments likewise to reject the excitation magnetic field when the measurements of the first and second measurement coils and also when the measurements of the first and third measuring coils are added.

8. The magnetometer according to claim 5, in which the first and second measuring coils (54, 56) are electrically connected in series in such a manner as to subtract the components B_{ty} channelled by the first and second cores (36, 38), respectively, from one another.

9. The magnetometer according to any one of the preceding claims, in which each core comprises at least one second sloping segment (42B, 48B; 126B) directed in a direction counter to that of the sloping first segment (42A, 48A; 126A), all the sloping segments directed in the same direction being grouped on the same side of the horizontal segment (40; 132) and all the sloping segments directed in the opposite direction being grouped on another side of the horizontal segment.

10. The magnetometer according to any one of the preceding claims, in which each core comprises more than ten sloping segments.

11. The magnetometer according to any one of the preceding claims, in which the magnetometer comprises:
- at least one additional magnetic core (10, 18) exhibiting a horizontal segment extending parallel to the plane XY in a secant direction to the direction Y likewise to channel a component Bₜₓ of the magnetic field measured along the direction X and
- excitation (12, 20) and measuring (14, 22) coils wrapped about this additional horizontal segment to measure the component Bₜₓ.

12. A method of manufacturing a fluxgate magnetometer for measuring a component B_{tz} of a magnetic field along a direction Z, said method comprising:
- the supply (60) of a substrate extending substantially parallel to a plane XY parallel to the horizontal directions X and Y perpendicular to the direction Z,
- the deposition and/or etching (84) on the substrate of a horizontal segment of a magnetic core, said horizontal segment extending parallel to the direction Y to channel a component B_{ty} of the magnetic field,
- the deposition and/or etching (66, 70, 90, 94) of an excitation coil and a measuring coil wrapped about the horizontal segment to measure the intensity of the magnetic field in this horizontal segment,
**characterized in that** the method likewise comprises the deposition and/or etching (78, 82, 104, 108) of a sloping segment of the core, said sloping segment extending in a direction beyond the plane XY and being capable of directing at least a fraction of the magnetic flux of the component B_{tz} towards the horizontal segment.
